# EUROPEAN PATENT APPLICATION

(11) **EP 4 557 354 A1**
(43) Date of publication of application: **21.05.2025**
(21) Application number: 23838682.5
(22) Date of filing: 27.06.2023
(51) Int. Cl.: H01L 21/67

(54) **SEMICONDUCTOR PROCESS APPARATUS**

(30) Priority: 13.07.2022 CN 202210819868
(71) Applicant: Beijing NAURA Microelectronics Equipment Co., Ltd., Beijing 100176 (CN)
(72) Inventor: GAO, Shang, Beijing 100176 (CN); ZHANG, Bo, Beijing 100176 (CN); HUANG, Mintao, Beijing 100176 (CN); LUO, Nan, Beijing 100176 (CN); WANG, Xiaohang, Beijing 100176 (CN); QIAN, Cuncun, Beijing 100176 (CN)
(74) Representative: LifeTech IP Spies & Behrndt Patentanwälte PartG mbB
(86) International application number: PCT/CN2023/102565
(87) International publication number: WO 2024/012188

(57) **Abstract**

The present disclosure provides a semiconductor process apparatus. In the provided semiconductor process apparatus, a driving device is disposed at a process door, and is connected to a boat support part disposed in a process chamber for driving the boat support part to rotate; a protective gas pipeline is disposed at a cavity, and is configured to introduce a protective gas for isolating a process gas from the driving device; the process door is movably connected to an opening of the cavity, and is configured to close or open the opening, and the process door and the cavity enclose the process chamber when the process door closes the opening; the process door is provided with a gas intake passage, and a first port of the gas intake passage is adjacent to the driving device, and is configured to convey the protective gas; and a second port of the gas intake passage is joined to the protective gas pipeline in a state of the process door closing the opening; and a first heating device is connected to a portion of the protective gas pipeline which is exposed from the cavity, and is configured to heat the protective gas pipeline. The above technical solution can solve a problem of serious deposition of a by-product in the process chamber which is caused because the protective gas enters the process chamber before reaching a preset temperature.

## Description

### TECHNICAL FIELD

The present disclosure relates to the technical field of semiconductor process apparatuses, and particularly relates to a semiconductor process apparatus.

### BACKGROUND

A semiconductor process apparatus is a main apparatus for processing wafers, and various process gases may exist in a process chamber of the semiconductor process apparatus, and include a corrosive gas such as hydrogen chloride gas. In order to prevent the corrosive gas from corroding a driving device in the semiconductor process apparatus, the corrosion of the driving device by the corrosive gas is isolated with a protective gas in the related art. Meanwhile, in order to avoid an influence of deposition of a by-product in the process chamber on a wafer to be processed, the protective gas entering the process chamber needs to be heated to a preset temperature or higher.

In the related art, a pipeline for the protective gas is disposed at a process door, the process door is movably connected to a cavity through a movable drag chain, a part of the pipeline is disposed in the movable drag chain, the part of the pipeline inside the movable drag chain cannot be heated due to repeated movements of the movable drag chain, and the space where the process door is located is small, such that a part of the pipeline where heating on the protective gas can be performed is short, with the result that the protective gas enters the process chamber before the temperature of the protective gas reaches the preset temperature, that is, the protective gas enters the process chamber at a lower temperature, which causes serious deposition of the by-product in the process chamber.

### SUMMARY

Embodiments of the present disclosure aim to provide a semiconductor process apparatus for solving the above-mentioned problem that the serious deposition of the by-product in the process chamber is caused because the protective gas enters the process chamber before reaching the preset temperature.

In order to solve the above technical problem, the present disclosure is implemented in a follow way.

In a first aspect, an embodiment of the present disclosure provides a semiconductor process apparatus, including a cavity, a process door, a driving device, a boat support part, a protective gas pipeline, and a first heating device; wherein
the driving device is disposed at the process door, and is connected to the boat support part disposed in a process chamber for driving the boat support part to rotate;
the protective gas pipeline is disposed at the cavity, and is configured to introduce a protective gas for isolating a process gas from the driving device;
the process door is movably connected to an opening of the cavity, and is configured to close or open the opening, and the process door and the cavity enclose the process chamber when the process door closes the opening; the process door is provided with a gas intake passage, and a first port of the gas intake passage is adjacent to the driving device, and is configured to convey the protective gas; and a second port of the gas intake passage is joined to the protective gas pipeline in a state of the process door closing the opening; and
the first heating device is connected to a portion of the protective gas pipeline which is exposed from the cavity, and is configured to heat the protective gas pipeline.

The technical solution adopts in the present disclosure can produce the following beneficial effect.

The semiconductor process apparatus provided in the embodiments of the present disclosure makes an improvement in a structure of the semiconductor process apparatus in the related art; by disposing the protective gas pipeline at the cavity, since the cavity does not need to be moved in a process of closing the opening of the cavity by the process door to enclose the process chamber by the processor door and the cavity, movement of the protective gas pipeline disposed at the cavity can be avoided; moreover, since the space outside the cavity is larger, a long pipeline used as the protective gas pipeline can be disposed outside the cavity, so that the first heating device can heat the long pipeline used as the protective gas pipeline, thereby heating the protective gas in the protective gas pipeline to the preset temperature before the protective gas enters the process chamber. Thus, the problem of the serious deposition of the by-product in the process chamber which is caused because the protective gas enters the process chamber before reaching the preset temperature can be avoided.

### BRIEF DESCRIPTION OF DRAWINGS

FIG. 1 is a sectional view of a semiconductor process apparatus according to an embodiment of the present disclosure;
FIG. 2 is a schematic diagram of a semiconductor process apparatus in a case where a process door is separated from a cavity according to an embodiment of the present disclosure;
FIG. 3 is an enlarged view of part of structures shown in FIG. 2; and
FIG. 4 is a three-dimensional schematic structural diagram of a semiconductor process apparatus according to an embodiment of the present disclosure.

Description of the reference numerals:
100-cavity, 110-cavity body, 111-opening, 120-flange, 121-connecting passage, 130-cavity sealing surface;
200-process door, 210-gas intake passage, 211-first port, 212-second port, 213-annular sinking groove, 214-passage body;
300-driving device;
400- boat support part, 410-rotating shaft, 420-support tray;
500-protective gas pipeline;
610-first heating device, 620-second heating device;
700-process chamber;
800-sealing assembly, 810-first seal ring, 820-second seal ring;
910-air outlet gap, 920-first assembly gap, 930-second assembly gap;
1000-fixing frame.

### DETAIL DESCRIPTION OF EMBODIMENTS

The technical solutions provided in the embodiments of the present disclosure are clearly and thoroughly described below with reference to the drawings for the embodiments of the present disclosure. Apparently, the embodiments described herein are just some embodiments of the present disclosure, and do not cover all embodiments. All other embodiments derived by those of ordinary skill in the art from the embodiments described herein without inventive work fall within the scope of the present disclosure.

The terms "first", "second" and the like in the description and the claims of the present disclosure are used for distinguishing between similar objects, but not necessarily for describing a particular order or a chronological order. It should be understood that the data such used may be interchanged under appropriate circumstances, so as to allow the embodiments of the present disclosure to be implemented in an order other than those illustrated or described herein; and the objects distinguished by the terms "first", "second" and the like generally belong to one kind, and the number of the objects is not limited, for example, the number of a first object may be one or more. In addition, the term "and/or" in the description and the claims indicates at least one of the objects connected by the term "and/or", and the forward slash "/" generally indicates that the object before "/" and the object after "/" are in an "or" relationship.

With reference to the drawings, semiconductor process apparatus provided in the embodiments of the present disclosure is described in detail below in conjunction with specific embodiments and application scenarios.

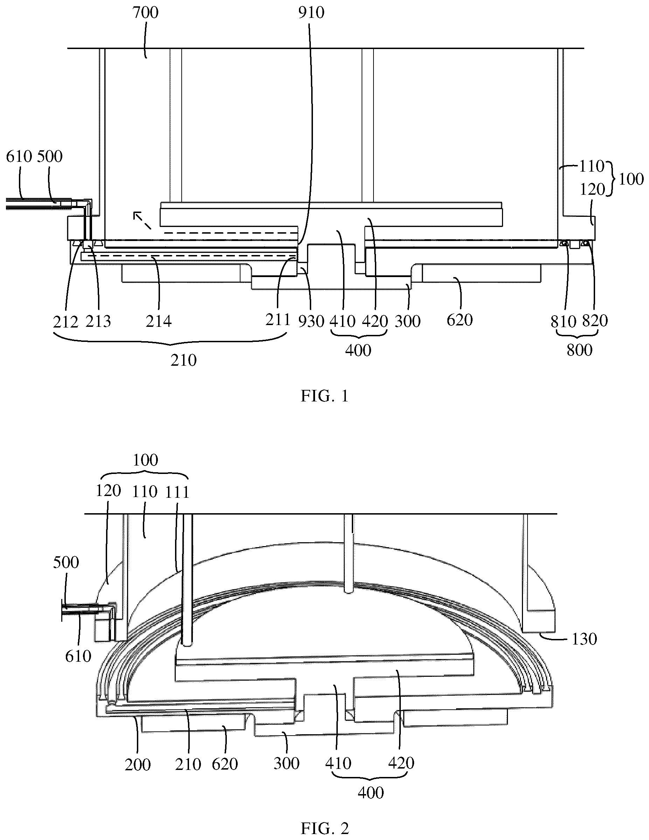

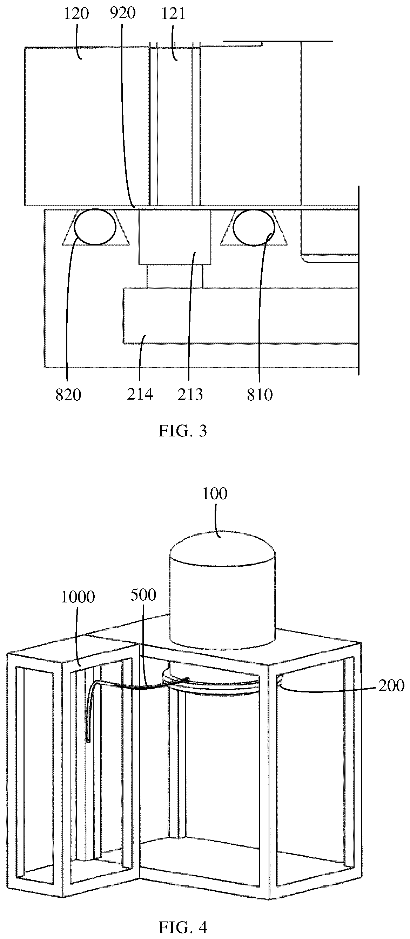

As shown in FIG. 1 to FIG. 4, an embodiment of the present disclosure provides a semiconductor process apparatus, which includes a cavity 100, a process door 200, a driving device 300, a boat support part 400, a protective gas pipeline 500, and a first heating device 610.

The process door 200 is movably connected to an opening 111 of the cavity 100, and is configured to close or open the opening 111; when the process door 200 is moved to a blocking position for closing the opening 111, the process door 200 is matched with the opening 111, thereby blocking the opening 111; and when the process door 200 is moved to an opening position for opening the opening 111, the opening 111 is opened to allow a wafer boat to pass. Optionally, a movable connection manner between the cavity 100 and the process door 200 is rotatable connection or movable connection, so that the process door 200 may be rotated or moved between the blocking position and the opening position for the opening 111.

In a case where the process door 200 closes the opening 111, the process door 200 is configured to cover the opening 111, so that the process door 200 and the cavity 100 enclose a process chamber 700 which is a reaction chamber for a wafer to be processed. The boat support part 400 is disposed in the process chamber 700, and the boat support part 400 is capable of placing thereon a wafer boat bearing the wafer to be processed, so as to play a role of bearing the wafer to be processed indirectly. The driving device 300 is disposed at the process door 200, and is connected to the boat support part 400 disposed in the process chamber 700 for driving the boat support part 400 to rotate, so as to ensure consistency of process conditions during the process. In an operating process of the semiconductor process apparatus, a process gas for processing the wafer to be processed exists in the process chamber 700, a wafer boat bearing the wafer to be processed may be placed on the boat support part 400, and the driving device 300 is disposed at the process door 200, is connected to the boat support part 400 disposed in the process chamber 700, and is capable of driving the boat support part 400 to rotate, so that the boat support part 400 may drive the wafer to be processed to rotate together, so as to enable the process gas to process the wafer to be processed uniformly.

The protective gas pipeline 500 is disposed at the cavity 100, and is configured to introduce a protective gas for isolating the process gas from the driving device. The protective gas may be an inert gas, and specifically, the protective gas may be nitrogen. The protective gas may be of other kinds, and the kind of the protective gas is not particularly limited in the embodiments of the present disclosure. The process door 200 is provided with a gas intake passage 210. In a case where the process door 200 covers the opening 111 of the cavity 100 to close the opening 111, that is, the process door 200 and the cavity 100 enclose the process chamber 700, a second port 212 of the gas intake passage 210 is joined to the protective gas pipeline 500, so that the protective gas in the protective gas pipeline 500 may be introduced into the gas intake passage 210 of the process door 200; and a first port 211 of the gas intake passage 210 is adjacent to the driving device 300, so that the protective gas in the protective gas pipeline 500 may purge the driving device 300 through the first port 211, that is, the protective gas pipeline 500 and the gas intake passage 210 can play a role in conveying the protective gas which isolates the process gas from the driving device 300, so that a corrosive gas in the process gas can be prevented from being in contact with the driving device 300 and corroding the driving device 300.

In an alternative embodiment, in a case where the opening 111 is opened because at least part of the process door 200 is separated from the cavity 100, the second port 212 of the gas intake passage 210 is separated from the protective gas pipeline 500.

The first heating device 610 is connected to a portion of the protective gas pipeline 500 which is exposed from the cavity 100, and is configured to heat the protective gas pipeline 500, so that the first heating device 610 may heat the portion of the protective gas pipeline 500 which is exposed from the cavity 100. Moreover, the space outside the cavity 100 is larger than the space at a bottom of the process door 200, and the cavity 100 does not need to be moved in the process of matching the opening 111 of the cavity 100 with the process door 200, so that a long pipeline used as the protective gas pipeline 500 may be disposed outside the cavity 100. Thus, the first heating device 610 may heat the long pipeline used as the protective gas pipeline 500, so that it can be ensured that the protective gas in the protective gas pipeline 500 is heated to the preset temperature or higher by the first heating device 610 while passing through the long pipeline, which can solve the problem of the serious deposition of the by-product in the process chamber 700 due to the low temperature of the protective gas entering the process chamber 700. The preset temperature may vary according to actual requirements of reactions carried out in the process chamber 700. In the present disclosure, the preset temperature may be 150°C, but certainly, the preset temperature may take other values, and the specific value of the preset temperature is not particularly limited in the embodiments of the present disclosure.

The semiconductor process apparatus provided in the embodiments of the present disclosure makes an improvement in a structure of the semiconductor process apparatus in the related art; by disposing the protective gas pipeline 500 at the cavity 100, since the cavity 100 does not need to be moved in the process of closing the opening 111 of the cavity 100 by the process door 200 to enclose the process chamber 700 by the processor door 200 and the cavity 100, movement of the protective gas pipeline 500 disposed at the cavity 100 can be avoided, and the phenomenon that most of the protective gas pipeline 500 is covered due to the protective gas pipeline 500 being disposed in the drag chain can be avoided; moreover, since the space outside the cavity 100 is larger, a long pipeline used as the protective gas pipeline 500 can be disposed outside the cavity 100, so that the first heating device 610 can heat the long pipeline used as the protective gas pipeline 500, thereby heating the protective gas in the protective gas pipeline 500 to the preset temperature or higher before the protective gas enters the process chamber 700. Thus, the problem of the serious deposition of the by-product in the process chamber 700 which is caused because the protective gas enters the process chamber 700 before reaching the preset temperature can be avoided.

In the semiconductor process apparatus provided in the embodiments of the present disclosure, the cavity 100 may include a cavity body 110 and a flange 120, the cavity body 110 is provided with the opening 111, the flange 120 is connected to the cavity body 110 and disposed around the opening 111, and the flange 120 protrudes in a direction away from a central axis of the opening 111. In such case, in an alternative embodiment, the protective gas pipeline 500 may be disposed at the flange 120 and pass through the flange 120, and an outlet end of the protective gas pipeline 500 is located at a joining face of the flange 120 where the flange 120 is joined to the second port 212, which can prevent the protective gas pipeline 500 from damaging structural strength of the cavity body 110. In order to achieve a good joining effect between the protective gas pipeline 500 and the gas intake passage 210, in another alternative embodiment, the flange 120 is provided with a connecting passage 121, the protective gas pipeline 500 is connected to the flange 120 and communicated with a gas inlet end of the connecting passage 121, and a gas outlet end of the connecting passage 121 is located at a joining face of the flange 120 where the flange 120 is joined to the second port 212. Both embodiments can achieve good connection between the protective gas pipeline 500 and the gas intake passage 210 while avoiding the damage to the cavity body 110. Herein, the central axis of the opening 111 is a central axis perpendicular to a plane where the opening 111 is located.

In an alternative embodiment, the flange 120 and the cavity body 110 may be an integral structure. Certainly, the flange 120 and the cavity body 110 may be separate structures and connected together by assembly.

In order to ensure good sealing performance between the cavity 100 and the process door 200 when the cavity 100 is connected to the process door 200, in another embodiment, an end face where the opening 111 of the cavity body 110 is located and a surface (i.e., the above joining face) of the flange 120 located on the same side may be located on a same plane, and form a cavity sealing surface 130. A sealing assembly 800 is disposed between the cavity sealing surface 130 and a corresponding surface of the process door 200, and the process door 200 is in sealing fit with the cavity sealing surface 130 through the sealing assembly 800.

In the above case, the cavity sealing surface 130 includes the end face where the opening 111 of the cavity body 110 is located and the surface of the flange 120 opposite to the process door 200. Therefore, compared with a cavity sealing surface only including the surface where the opening 111 of the cavity body 110 is located or a cavity sealing surface only including the surface of the flange 120 opposite to the process door 200, the cavity sealing surface 130 provided in the embodiments of the present disclosure has a larger area, which facilitates connection and sealing between the cavity 100 and the process door 200 through the cavity sealing surface 130. Optionally, the sealing assembly 800 may only be disposed between the flange 120 and the process door 200, or the sealing assembly 800 may only be disposed between the end face where the opening 111 is located and the process door 200, or part of the sealing assembly 800 may be disposed between the process door 200 and the flange 120, and the other part of the sealing assembly 800 may be disposed between the end face where the opening 111 is located and the process door 200. The specific position for disposing the sealing assembly 800 is not limited in the present disclosure.

The sealing assembly 800 may be formed in various ways, and a specific form of the sealing assembly 800 is provided in the embodiments of the present disclosure. Specifically, the sealing assembly 800 may include a first seal ring 810 and a second seal ring 820 disposed around the first seal ring 810, the second port 212 is located between the first seal ring 810 and the second seal ring 820, and both the first seal ring 810 and the second seal ring 820 are hermetically disposed between the cavity sealing surface 130 and the corresponding surface of the process door 200. In this case, in a circumferential direction of the process door 200, double sealing effects on the cavity 100 and the process door 200 can be achieved through the first seal ring 810 and the second seal ring 820 respectively, so that the sealing performance can be ensured in a case where the cavity 100 is connected to the process door 200. Moreover, since the second port 212 is located between the first seal ring 810 and the second seal ring 820, the first seal ring 810 and the second seal ring 820 can play a role in sealing the protective gas at the second port 212 when the protective gas flows at the second port 212, so that the protective gas at the second port 212 can be prevented from overflowing out of the cavity 100 or directly entering the process chamber 700.

In addition, what is conveyed through the second port 212 is the protective gas, and the protective gas may serve as a gas seal, so that assembly sealability between the cavity 100 and the process door 200 can be further improved by the gas seal together with the first seal ring 810 and the second seal ring 820. Thus, the protective gas can be used for two purposes.

In the semiconductor process apparatus provided in the embodiments of the present disclosure, the gas intake passage 210 may include a passage body 214 and an annular sinking groove 213, a first passage-body port of the passage body 214 is provided at a bottom wall of the annular sinking groove 213, a second passage-body port of the passage body 214 is the first port 211, a notch of the annular sinking groove 213 is the second port 212, a first assembly gap 920 is enclosed by the process door 200, the flange 120, the first seal ring 810, and the second seal ring 820, the first assembly gap 920 surrounds the first seal ring 810, and the annular sinking groove 213 is opposite to and communicated with the first assembly gap 920.

In the above case, the protective gas in the protective gas pipeline 500 may enter the first passage-body port of the passage body 214 through the notch of the annular sinking groove 213, so that the protective gas arriving at the first passage-body port may flow along the passage body 214 towards the second passage-body port of the passage body 214, thereby entering the process chamber 700 through the first port 211. Meanwhile, since the first assembly gap 920 surrounding the first seal ring 810 is opposite to and communicated with the annular sinking groove 213, an effect of expanding the space around the first assembly gap 920 is realized, so that the gas may flow well in the first assembly gap 920. Therefore, when a vacuum environment needs to be created in the process chamber 700, both the gas in the first assembly gap 920 and the gas in the annular sinking groove 213 can be easily pumped out, which facilitates an improvement in vacuum pumping efficiency during the vacuum pumping of the process chamber 700.

In another embodiment, the number of passage bodies 214 may be more than one, the first passage-body port of each passage body 214 is provided at the bottom wall of the annular sinking groove 213, and the second passage-body port of each passage body 214 is the first port 211. In this case, the protective gas may enter the process chamber 700 through a plurality of passage bodies 214, so as to facilitate the protection of the drive device 300 by the protective gas. Moreover, in order to enable the protective gas to protect the driving device 300 completely, a plurality of second passage-body ports of the plurality of passage bodies 214 may be formed around the driving device 300, so that the protective gas may purge the driving device 300 from all around the driving device 300, and the protective gas around the driving device 300 may better prevent the corrosive gas in the process chamber 700 from being in contact with the driving device 300 and corroding the driving device 300.

In an alternative embodiment, an orthographic projection of the connecting passage 121 on a cross section perpendicular to a central axis of the connecting passage 121 may be located within an orthographic projection of the annular sinking groove 213 on the cross section, the connecting passage 121 is communicated with the annular sinking groove 213 through the first assembly gap 920, a first size of the connecting passage 121 is smaller than a width of the notch of the annular sinking groove 213, and the first size is a size of the connecting passage 121 in a width direction of the notch. In this case, a port of the connecting passage 121 which is connected to the annular sinking groove 213 is smaller than the notch of the annular sinking groove 213, so that all the protective gas conveyed in the connecting passage 121 may be rapidly introduced into the passage body 214 through the annular sinking groove 213. Meanwhile, the annular sinking groove 213 has a larger cross-sectional area (i.e., an area of a cross section perpendicular to the central axis) than the connecting passage 121, so that the annular sinking groove 213 occupies a larger space, which facilitates the flowing of the gas between the first assembly gap 920 and the annular sinking groove 213. When the vacuum environment needs to be created in the process chamber 700, the annular sinking groove 213 which occupies the larger space can reduce the resistance to the flowing of the gas, so that the gas in the first assembly gap 920 can be completely pumped out, which can further improve the vacuum pumping efficiency during the vacuum pumping in the process chamber 700.

In the embodiments of the present disclosure, the semiconductor process apparatus may further include a second heating device 620 disposed on an outer surface of the process door 200 away from the process chamber 700; and the second heating device 620 is configured to heat the protective gas flowing through the gas intake passage 210, so that the protective gas, which is heated to the preset temperature or higher in the protective gas pipeline 500, can be continuously heated while flowing through the gas intake passage 210, thereby preventing the temperature of the protective gas from being reduced below the preset temperature while the protective gas heated to the preset temperature or higher is flowing through the gas intake passage 210.

The first heating device 610 capable of heating the protective gas pipeline 500 may be of various types, and in an optional embodiment, the first heating device 610 may be a heating tape wound round the protective gas pipeline 500, in which case the heating tape may be directly wound round the protective gas pipeline 500, so that a distance between the heating tape and the protective gas in the protective gas pipeline 500 is relatively small, which facilitates an improvement in the efficiency of heating the protective gas by the first heating device 610; moreover, with the heating tape wound round the protective gas pipeline 500, the occupied space can be reduced. The first heating device 610 may also be a heating wire, which may be wound round the protective gas pipeline 500 to heat the protective gas pipeline 500. Certainly, the first heating device 610 may include both a heating tape and a heating wire according to actual needs, so as to facilitate achieving the purpose of heating the protective gas to the preset temperature or higher. A specific method of the first heating device 610 for heating the protective gas in the protective gas pipeline 500 is not limited in the embodiments of the present disclosure.

In the semiconductor process apparatus provided in the embodiments of the present disclosure, the boat support part 400 may include a rotating shaft 410 and a support tray 420, the driving device 300 is connected to the rotating shaft 410, the support tray 420 is capable of rotating along with the rotating shaft 410, the process door 200 may be provided with a mounting hole, and the driving device 300 is mounted in the mounting hole and connected to the rotating shaft 410; and a second assembly gap 930 is formed between the driving device 300 and a hole wall, the first port 211 is formed at the hole wall of the mounting hole and communicated with the second assembly gap 930, and an air outlet gap 910 is formed between the rotating shaft 410 and the process door 200 and communicated with the first port 211.

In the above case, the driving device 300 drives the rotating shaft 410 to rotate, so that the rotating shaft 410 may drive the support tray 420 to rotate; and, with the first port 211 formed at the hole wall of the mounting hole, since the first port 211 is communicated with the second assembly gap 930, the protective gas blown out from the first port 211 may be blown into the second assembly gap 930, so as to avoid the contact between the driving device 300 and the corrosive gas. Meanwhile, since the air outlet gap 910 is communicated with the first port 211, the protective gas blown out from the first port 211 may be blown into the air outlet gap 910, so that the corrosive gas in the process chamber 700 may be prevented from continuously diffusing towards the driving device 300, that is, the protective gas in the air outlet gap 910 has an intercepting effect on the corrosive gas tending to diffuse into the second assembly gap 930, thereby protecting the driving device 300.

Optionally, the second assembly gap 930 may be communicated with the air outlet gap 910 formed between the support tray 420 and the process door 200, so that the protective gas blown out from the first port 211 after entering the gas intake passage 210 may be first blown into the second assembly gap 930 and then blown into the air outlet gap 910 from the second assembly gap 930, so that a clear gas path is provided for the protective gas from the protective gas pipeline 500 to the process chamber 700, which facilitates a more stable protective effect of the protective gas on the driving device 300.

Meanwhile, since the second assembly gap 930 and the air outlet gap 910 may be made smaller during design and assembly processes, the protective gas can serve as a gas seal for the driving device 300 through the second assembly gap 930 and the air outlet gap 910 under the condition that the first port 211 has certain air output, thereby improve the protective effect of the protective gas on the driving device 300. In addition, with the first port 211 communicated with the second assembly gap 930, the protective gas can form gas isolation at a close position, thereby improving the protective effect.

The semiconductor process apparatus provided in the embodiments of the present disclosure may be of various types. Optionally, the semiconductor process apparatus provided in the embodiments of the present disclosure may be a vertical furnace. Certainly, the semiconductor process apparatus provided in the embodiments of the present disclosure may be of other specific types. The semiconductor process apparatus may further include a fixing frame 1000, and the cavity 100 is fixed on the fixing frame 1000, so that the fixing frame 1000 can fix and support the cavity 100, so as to ensure stability of the cavity 100 in the operating process thereof.

It should be noted that, in the present disclosure, the terms "includes", "comprises" or any other variation thereof are intended to indicate a non-exclusive inclusion, so that a process, method, article, or device, which includes a series of elements, does not only include those listed elements but also include other elements which are not explicitly listed, or the elements inherent in such process, method, article, or device. If there are no more limitations, limiting an element by "including a..." does not exclude the existence of other identical elements in the process, method, article, or device which includes the element.

The embodiments of the present disclosure are described above with reference to the drawings, but the present disclosure is not limited to the above specific implementations which are merely for illustration rather than for limitation. Enlightened by the present disclosure, those of ordinary skill in the art can make many variations without departing from the spirit of the present disclosure and the scope of the claims, and all those variations should be considered to fall within the scope of the present disclosure.

## Claims

1. A semiconductor process apparatus, comprising a cavity, a process door, a driving device, a boat support part, a protective gas pipeline, and a first heating device; wherein
the driving device is disposed at the process door, and is connected to the boat support part disposed in a process chamber for driving the boat support part to rotate;
the protective gas pipeline is disposed at the cavity, and is configured to introduce a protective gas for isolating a process gas from the driving device;
the process door is movably connected to an opening of the cavity, and is configured to close or open the opening, and the process door and the cavity enclose the process chamber when the process door closes the opening; the process door is provided with a gas intake passage, and a first port of the gas intake passage is adjacent to the driving device, and is configured to convey the protective gas; and a second port of the gas intake passage is joined to the protective gas pipeline in a state of the process door closing the opening; and
the first heating device is connected to a portion of the protective gas pipeline which is exposed from the cavity, and is configured to heat the protective gas pipeline.

2. The semiconductor process apparatus of claim 1, wherein the cavity comprises a cavity body and a flange, the cavity body is provided with the opening, the flange is connected to the cavity body and disposed around the opening, and the flange protrudes in a direction away from a central axis of the opening, wherein:
the protective gas pipeline is disposed at the flange and passes through the flange, and an outlet end of the protective gas pipeline is located at a joining face of the flange where the flange is joined to the second port; or,
the flange is provided with a connecting passage, the protective gas pipeline is connected to the flange and communicated with a gas inlet end of the connecting passage, and a gas outlet end of the connecting passage is located at a joining face of the flange where the flange is joined to the second port.

3. The semiconductor process apparatus of claim 2, wherein an end face where the opening of the cavity body is located and the joining face of the flange are located on a same plane, and form a cavity sealing surface, a sealing assembly is disposed between the cavity sealing surface and a corresponding surface of the process door, and the process door is in sealing fit with the cavity sealing surface through the sealing assembly.

4. The semiconductor process apparatus of claim 3, wherein the sealing assembly comprises a first seal ring and a second seal ring disposed around the first seal ring, the second port is located between the first seal ring and the second seal ring, and both the first seal ring and the second seal ring are hermetically disposed between the cavity sealing surface and the corresponding surface of the process door.

5. The semiconductor process apparatus of claim 4, wherein the gas intake passage comprises a passage body and an annular sinking groove, a first passage-body port of the passage body is provided at a bottom wall of the annular sinking groove, a second passage-body port of the passage body is the first port, a notch of the annular sinking groove is the second port, a first assembly gap is enclose d by the process door, the flange, the first seal ring, and the second seal ring, and the annular sinking groove is opposite to and communicated with the first assembly gap.

6. The semiconductor process apparatus of claim 5, wherein a number of passage bodies is more than one, a first passage-body port of each of the passage bodies is provided at the bottom wall of the annular sinking groove, and a second passage-body port of each of the passage bodies is the first port.

7. The semiconductor process apparatus of claim 5, wherein an orthographic projection of the connecting passage on a cross section perpendicular to a central axis of the connecting passage is located within an orthographic projection of the annular sinking groove on the cross section, the connecting passage is communicated with the annular sinking groove through the first assembly gap, a first size of the connecting passage is smaller than a width of the notch of the annular sinking groove, and the first size is a size of the connecting passage in a width direction of the notch.

8. The semiconductor process apparatus of claim 1, further comprising a second heating device, wherein the second heating device is disposed on an outer surface of the process door away from the process chamber, and is configured to heat the protective gas flowing through the gas intake passage.

9. The semiconductor process apparatus of claim 1, wherein the boat support part comprises a rotating shaft and a support tray, the rotating shaft is connected to the support tray, the process door is provided with a mounting hole, and the driving device is mounted in the mounting hole and connected to the rotating shaft; a second assembly gap is formed between the driving device and a hole wall of the mounting hole, and the first port is formed at the hole wall of the mounting hole and communicated with the second assembly gap; and an air outlet gap is formed between the rotating shaft and the process door and communicated with the first port.

10. The semiconductor process apparatus of any one of claims 1 to 9, wherein the semiconductor process apparatus is a vertical furnace, and further comprises a fixing frame on which the cavity is fixed.
